# EUROPEAN PATENT APPLICATION

(11) **EP 4 773 788 A1**
(43) Date of publication of application: **08.07.2026**
(21) Application number: 25150237.3
(22) Date of filing: 03.01.2025
(51) Int. Cl.: H10N 60/01, H10N 60/80, H10N 69/00

(54) **JOSEPHSON JUNCTION-BASED CIRCUIT DEVICE AND TOPOLOGICAL CIRCUIT DEVICE, AND METHOD OF MANUFACTURING THE CIRCUIT DEVICE**

(71) Applicant: Friedrich-Alexander-Universität Erlangen-Nürnberg, in Vertretung des Freistaates Bayern, 91058 Erlangen (DE)
(72) Inventor: Eichler, Christopher, 91058 Erlangen (DE); Milosavljevic, Momcilo, 91058 Erlangen (DE)
(74) Representative: Kobiako von Gamm, Iouri

(57) **Abstract**

The disclosed method of manufacturing a circuit device comprises forming a Josephson junction (2) and a circuit element (4), spaced apart from the Josephson junction by a lateral gap (LG), on a substrate (1), and forming an air bridge (3) for electrically coupling the Josephson junction with the circuit element, wherein the air bridge bridges the lateral gap without making contact to the substrate. A corresponding circuit device as well as a topological circuit device, including several conductive islands, Josephson junctions, and air bridges coupling the junctions with the islands, are also disclosed.

## Description

### Technical field

The invention relates to a circuit device, a topological circuit device, and a method of manufacturing a circuit device, in particular for superconducting quantum circuits.

### Background

Quantum systems typically require scaling up the number of their individual building blocks that exhibit true quantum (nonlinear) behaviour, e.g., qubits, for most practical applications of quantum technologies such as quantum computing, quantum simulation or quantum sensing/metrology. Superconducting quantum circuits have emerged as a promising platform for scaling up quantum devices employing Josephson junctions as fundamental building blocks.

One of the most sensitive and critical stages of manufacturing and scaling up such superconducting circuits is establishing reliable and sufficient electrical coupling/contact between a Josephson junction and additional circuit elements such as a metallic base layer for further routing and grounding or to another Josephson junction for establishing coupling between Josephson junctions in a Josephson junction array.

In particular, in order to build useful and reliable scaled-up quantum devices it is important that contact surfaces stay clean before establishing electrical coupling/contact and detrimental effects, e.g., caused by native oxides on the surfaces of the contact areas and of the substrate beneath, are minimized as much as possible. Moreover, further damages of the device structure, e.g. caused by impurities or defects during the manufacturing process, need to be avoided in order to enable long coherence times.

However, the established methods for contacting or coupling to a Josephson junction have certain drawbacks, e.g., by requiring additional and complex processing steps, introducing surface roughness of the substrate, or adding additional oxides away from the contact area, which may deteriorate the circuit performance during deployment. Moreover, established methods are less flexible and are difficult to integrate with other process steps when manufacturing a circuit device. This seriously limits the applicability and scalability of the fabricated devices as well as the efficiency of the manufacturing process.

Thus, an object of the invention is to overcome such limitations and provide circuit devices and a method of manufacturing thereof that improve upon the available methods and devices.

### Summary

This object of the invention is achieved by a method of manufacturing a circuit device, a circuit device and a topological circuit device as described in the appended independent claims. Advantageous developments and embodiments are described in the dependent claims.

In a first aspect, the invention relates to a method of manufacturing a circuit device. The method comprises forming a first Josephson junction on a substrate. The method further comprises forming a first air bridge to establish an electrical coupling between the first Josephson junction and a first circuit device element, wherein the first circuit device element is arranged on the substrate and spaced apart from the first Josephson junction. The first air bridge bridges over a lateral gap extending from the first Josephson junction to the first circuit device element without making contact to the substrate.

Here and in the following "lateral" refers to a direction parallel to the surface of the substrate and "vertical" refers to a direction normal to the surface of the substrate.

The invention enables the fabrication of quantum circuit devices, in particular superconducting quantum circuit devices, in which (otherwise isolated) Josephson junctions can be electrically coupled to other circuit device elements on the substrate without making any direct physical contact to the substrate, thereby reducing dissipation and noise and improving coherence times. In particular, the usage of air bridges for establishing an electrical coupling reduces the contact area with the surface of the substrate and thus unwanted coupling with the surface. In this way, detrimental effects caused by surface defects and impurities of the substrate can be reduced, thereby improving the overall performance of the manufactured circuit devices. Moreover, by forming air bridges as coupling elements for Josephson junctions without making contact to the substrate further damage, e.g., to the surface of the substrate, caused by the manufacturing process itself can be avoided.

The substrate may be or comprise a core substrate. The core substrate may be substantially free from further conductive layers such as metallization and/or redistribution layers. For example, the core substrate may be made from silicon. The substrate may also comprise further, e.g., non-conductive, layers on the core substrate, e.g., dielectric, passivation or adhesion layers.

The first Josephson junction may comprise a first junction contact pad. The forming of the first Josephson junction may then also comprise forming a first junction contact pad over or on the substrate.

The first junction contact pad may be a portion of an electrode of the first Josephson junction or may be positioned on an electrode of the first Josephson junction. The first junction contact pad may correspond to the contact portion of the first Josephson junction for contacting the first air bridge. The first Josephson junction and/or the first junction contact pad (or a surface thereof) may overlap and/or make direct physical and/or electrical contact/connection to the first air bridge. The forming of the first air bridge may then comprise establishing a direct physical and/or electrical contact/connection between the first air bridge and the first Josephson junction and/or the first junction contact pad (or a surface thereof). The forming of the first air bridge may also comprise establishing a direct physical and/or electrical contact/connection between the first air bridge and the first circuit device element (or a surface thereof).

The method may further comprise forming a base layer on the substrate. The base layer may be formed before the first Josephson junction is formed. The base layer may be a conductive layer, e.g., a metal layer. Exemplarily, the base layer is made from Aluminium. The thickness of the base layer may be larger than a thickness of the first Josephson junction. The thickness of the circuit device element and/or the base layer may be larger than a thickness of an electrode of the first Josephson junction and/or the thickness of the first junction contact pad. The thickness of the base layer may be larger than 200 Nanometer.

The method may comprise patterning the base layer. The base layer may be formed and/or patterned before the first Josephson junction is formed. The patterning of the base layer may comprise exposing a portion of the surface of the substrate. The patterning of the base layer may comprise exposing a portion of the surface of the substrate by forming a lateral gap in the base layer.

The base layer may be patterned using lithography. Optionally, the method or the patterning of the base layer comprises forming a first resist layer on the base layer; patterning the first resist layer by forming at least one opening in the first resist layer; removing a portion of the base layer in/below the opening of the first resist layer to expose at least a portion of the surface of the substrate thereby forming the lateral gap in the base layer; and removing the (rest of the) first resist layer.

The forming a first Josephson junction on the substrate may comprise forming the first Josephson junction on the exposed surface of the substrate in the lateral gap of the patterned base layer. Preferably, the first Josephson junction is spaced apart from the patterned base layer (i.e., any portion thereof).

The first circuit device element may be or correspond to a portion of the patterned base layer on the substrate. The patterning of the base layer may comprise forming a first conductive island as a portion of the patterned base layer. The first circuit device element may be the first conductive island of the patterned base layer.

Alternatively, the first circuit device element may also be or correspond to a second Josephson junction. The first Josephson junction and the second Josephson junction may form a (coupled) Josephson junction array. In that case, the first air bridge establishes an electrical connection and/or coupling between the first and the second Josephson junction.

The Josephson junction array may be positioned in the lateral gap of the patterned base layer and/or on the surface of the substrate exposed by the patterning of the base layer. Optionally, the Josephson junction array may also be electrically coupled to a portion of the patterned base layer. For example, the first and/or second Josephson junction may be electrically coupled to the patterned base layer by another, e.g., a second, air bridge.

The method may further comprise forming at least one alignment marker on the substrate to assist the forming of the first air bridge when establishing a physical and/or electrical contact/connection to the first Josephson junction and/or the first junction contact pad. For example, the patterning of the base layer may comprise forming at least one first alignment marker as an isolated portion of the patterned base layer. The at least one first alignment marker may be indicative of the position of the first Josephson junction and/or the first junction contact pad for enabling alignment of the first Josephson junction and/or the first junction contact pad and the first air bridge when forming the first air bridge.

The at least one first alignment marker may be or correspond to an isolated portion of the patterned base layer that may be positioned in the vicinity of the first Josephson junction and/or the first junction contact pad. Optionally, the at least one first alignment marker may be spaced apart from the (rest of) the patterned base layer, the first Josephson junction, the first junction contact pad and/or the first circuit device element.

Preferably, the at least one first alignment marker has a distinct shape, e.g., different from a substantially rectangular shape and/or with more than four corners/edges, that allows a process tool for forming the first air bridge, e.g., an electron beam lithography tool, to recognize the at least one first alignment marker, thereby assisting the process tool in aligning the first air bridge with the first Josephson junction and/or the first junction contact pad during forming the first air bridge. For example, the at least one first alignment marker may have the shape of a cross, a star or some other easily recognizable shape.

The method may further comprise forming a second resist on the substrate and/or the patterned base layer for forming the first Josephson junction and/or the first junction contact pad. The method may further comprise forming openings in the second resist and forming the first Josephson junction and/or the first junction contact pad in the openings of the second resist. Optionally, the second resist is formed after the first resist for forming the patterned base layer is removed. Optionally, the method may comprise removing the second resist after forming the first Josephson junction and/or the first junction contact pad. Optionally, the second resist may be the same resist that is used to form the first air bridge (see further details below). Alternatively, the second resist is removed before forming the first air bridge.

The first Josephson junction (or any Josephson junction described herein) may comprise two electrodes and a tunnel barrier in between the two electrodes. For example, the first Josephson junction may comprise a bottom electrode layer, a tunnel barrier layer and a top electrode layer.

Each of the bottom electrode layer and the top electrode layer may comprise a junction overlap portion and an electrode extension portion. The tunnel barrier layer may be positioned between the junction overlap portions. The junction overlap portion of the bottom electrode may be directly on the substrate. The tunnel barrier layer may be positioned on the junction overlap portion of the bottom electrode layer. The junction overlap portion of the top electrode layer may be on the tunnel barrier layer such that the tunnel barrier layer is positioned between the junction overlap portions of the top and bottom electrode layer.

The electrode extension portions may be directly on the substrate. The electrode extension portion of the bottom electrode layer may be directly connected to the junction overlap portion of the bottom electrode layer. The electrode extension portion of the top electrode layer may be connected to the junction overlap portion of the top electrode layer by a sidewall portion of the top electrode layer. The sidewall portion of the top electrode layer may extend vertically along a sidewall portion of the tunnel barrier layer.

The electrode extension portions of the top electrode layer and the bottom electrode layer may each have an elongated shape in a lateral direction along the surface of the substrate. The electrode extension portions of the top electrode layer and the bottom electrode layer may form an angle that is smaller than 180 Degrees. Optionally, the electrode extension portions of the top electrode layer and the bottom electrode layer form a (substantially) right angle, e.g., are orthogonal with respect to each other.

Optionally, the bottom electrode layer and the top electrode layer are metal layers. Preferably, the bottom electrode layer and the top electrode layer are made from Aluminium. The tunnel barrier layer may be an oxide layer.

The first junction contact pad may be positioned directly on the substrate. For example, the first junction contact pad may be a portion of the first Josephson junction. Optionally, the first junction contact pad may at least be a portion of the top electrode layer or the bottom electrode layer. The first junction contact pad may be a portion of the electrode extension portion of the top or bottom electrode. The first junction contact pad may also be identical with the extension portion of the top or bottom electrode of the first Josephson junction.

The first junction contact pad may also be a separate layer positioned on the top electrode layer or the bottom electrode layer and/or on the electrode extension portion of the top or bottom electrode. Optionally, the first junction contact pad is made from a same material as the top electrode layer, the bottom electrode layer, the first air bridge and/or the first circuit device element. For example, the first junction contact pad is made from Aluminium.

The thickness of each of the first Josephson junction, the bottom electrode, the top electrode and/or the first junction contact pad may be smaller than the thickness of the first circuit device element. The thickness of each of the first Josephson junction, the bottom electrode, the top electrode and/or the first junction contact pad may be smaller than 200 Nanometer, preferably smaller than 100 Nanometer, most preferably smaller than 50 Nanometer.

The top electrode, the bottom electrode, and/or each one of the electrode extension portions may be tapered. The tapering may be directed towards the overlap region and/or the tunnel barrier layer of the first Josephson junction. Preferably, a width of the first junction contact pad and/or a width of an extension portion of the top and/or bottom electrode away from the overlap region (i.e., in the contact area of the first Josephson junction) is larger than a width of an overlap portion of the bottom and/or top electrode (i.e., a width of the bottom and/or top electrode in the overlap area or in the region of the tunnel barrier).

The method or the forming the first air bridge may comprise forming a (third) resist on the substrate and/or forming the patterned base layer for forming the first air bridge. The (third) resist for forming the first air bridge may be different from the first resist for forming the patterned base layer and/or the second resist for forming the first Josephson junction and/or the first junction contact pad. Alternatively, the (third) resist for forming the first air bridge may also be the same resist that is used for forming the first Josephson junction and/or the first junction contact pad (for details see further below). In this case, the second resist and the third resist may be a same/common resist.

The method may comprise patterning the (third) resist for forming the first air bridge. The patterning of the (third) resist may comprise forming an opening in the (third) resist for forming the first air bridge. Optionally, the patterning the (third) resist may comprise exposing a surface of the first Josephson junction and/or the first junction contact pad and/or at least a portion of a surface of the first circuit device element.

Optionally, the patterning of the (third) resist comprises bringing at least a portion of the resist into a bridge-like shape. The bridge-like shaped portion of the (third) resist may bridge over an entire lateral gap along the surface of the substrate extending from the first Josephson junction and/or the first junction contact pad to the first circuit device element.

The patterning of the (third) resist, e.g., to form the bridge-like shape, may be carried out by using grayscale electron beam lithography. This will allow to form a bridge-like shape with a large flexibility w.r.t size and shape of the bridge-like shaped portion of the (third) resist (and thus of the first air bridge). Preferably, the forming of the opening in the (third) resist for forming the air bridge and/or the bringing the portion of the (third) resist into a bridge-like shape is carried out without exposing the surface of the substrate, e.g., below the bridge-like shape and/or without exposing the surface of the substrate along the entire lateral gap along the substrate extending from the first Josephson junction and/or the first junction contact pad to the first circuit device element.

The patterning of the (third) resist and/or the gray-scale electron beam lithography may be carried out by using an electron beam lithography tool. Optionally, the patterning of the (third) resist and/or the forming of the bridge-like shape of the (third) resist may be carried out by using the at least one alignment marker for aligning the electron beam lithography tool with the first Josephson junction and/or the first junction contact pad as described further above.

The thickness of the third resist may be equal or larger than 1 Micrometer. The thickness of the third resist may also be equal or larger than 3 Micrometer.

The method and/or the forming of the first air bridge may comprise depositing a conductive material layer to form the first air bridge. The conductive material layer may be made from the same material as a material of the first Josephson junction and/or the first junction contact pad, the first circuit device element and/or the (patterned) base layer. For example, the conductive material layer may be made from Aluminum. The conductive material layer for the first air bridge may be deposited directly on the bridge-like shape of the (third) resist, at least an exposed portion of the first Josephson junction and/or the first junction contact pad and/or at least an exposed portion of the first circuit device element. The conductive material layer may not be deposited on the surface of the substrate.

Optionally, the thickness of the conductive material layer and/or the air bridge is in a range between 100 Nanometer and 500 Nanometer, preferably in a range between 300 Nanometer and 500 Nanometer.

The method may further comprise removing the (third) resist after the depositing of the conductive material layer. Optionally, the method comprises removing at least the bridge-like shaped portion of the resist under the deposited conductive material layer after the depositing of the conductive material layer (to obtain the first air bridge). The method may also comprise removing (substantially) all of the (third) resist for forming the first air bridge (still) remaining on the first Josephson junction, the first junction contact pad, the first circuit device element, the patterned base layer and/or the surface of the substrate after the depositing of the conductive material layer.

The patterning of the (third) resist may comprise exposing at least a portion of the surface of the first Josephson junction and/or the first junction contact pad and cleaning the exposed surface of the first Josephson junction and/or the first junction contact. The cleaning of the surface of the first Josephson junction and/or the first junction contact pad may be carried out before depositing the conductive material layer to form the first air bridge. The cleaning of the exposed surface of the first Josephson junction and/or the first junction contact pad may comprise ion milling.

The patterning of the resist may comprise exposing at least a portion of the surface of the first circuit device element and cleaning the exposed surface of the first circuit device element. The cleaning of the surface of the first circuit device element may be carried out before depositing the conductive material layer to form the first air bridge. The cleaning of the exposed surface of the first circuit device element may comprise ion milling.

The cleaning of the first Josephson junction and/or the first junction contact pad and the cleaning of the first circuit device element may be carried out simultaneously.

Preferably, the first air bridge may be completely gapped from the substrate by a vertical gap (normal to the surface of the substrate). The vertical gap may be larger or equal to a thickness of the first Josephson junction and/or a thickness of the first circuit device element. The minimal distance of the first air bridge and/or the deposited conductive material layer from the surface of the substrate may correspond to a minimum of the vertical gap along the surface of the substrate and/or a thickness of the first Josephson junction. Here, the thickness of the first Josephson junction may correspond to the thickness of an electrode of the first Josephson junction, a thickness of the first junction contact pad and/or the sum of the thickness of an electrode of the first Josephson junction and a thickness of the first junction contact pad.

Optionally, the minimal vertical gap between the surface of the substrate and the first air bridge is larger than 0, preferably equal or larger than 50 Nanometer. Optionally, the maximum of the vertical (air) gap between the surface of the substrate and the first air bridge (e.g., the surface of the first air bridge facing the surface of the substrate) is equal or larger than the thickness of the first circuit device element and/or the patterned base layer. Optionally, the maximum of the vertical (air) gap is equal or larger than 200 Nanometer, preferably equal or larger than 300 Nanometer, most preferably equal or larger than 500 Nanometer. The vertical gap may be in a range between 50 nanometer and 1 Micrometer, optionally in a range between 300 Nanometer and 1 Micrometer.

A (lateral) length of the first air bridge may be in a direction pointing from the first Josephson junction and/or the first junction contact pad to the first circuit device element. The length of the first air bridge may be equal or larger than the minimal lateral gap between the first Josephson junction and/or the first junction contact pad and the first circuit device element.

The length of the first air bridge may be larger than 3 Micrometer, preferably larger than 10 Micrometer. The length of the first air bridge may be in a range between 3 Micrometer and 30 Micrometer.

A lateral width of the first air bridge may be in a direction substantially perpendicular to the length direction (as defined above) and/or along the elongation direction of an extension portion of the top or bottom electrode layer of the first Josephson junction and/or in a direction of the width of the first junction contact pad.

A lateral width of the first air bridge may be smaller than 10 Micrometer, preferably smaller than 5 Micrometer. A lateral width of the first air bridge may be in a range from 500 Nanometer to 10 Micrometer, preferably in the range from 500 Nanometer to 5 Micrometer.

An overlap area and/or physical contact area between the first air bridge and the first Josephson junction and/or the first junction contact pad may have a lateral width, e.g., in the length direction of the first air bridge, that is larger than 0 and/or smaller than 1 Micrometer, preferably in a range between 50 Nanometer and 1 Micrometer, optionally in a range between 300 Nanometer and 1 Micrometer.

Optionally, the first air bridge comprises a first bridge contact portion, a second bridge contact portion and a bridge center portion.

The first bridge contact portion may be overlapping and in electrical and/or physical contact with the first Josephson junction and/or the first junction contact pad. The second bridge contact portion may be overlapping and in electrical and/or physical contact with the first circuit device element.

The first and/or second bridge contact portion or at least a portion thereof may comprise or be in the shape of a pad. The pad may have a planar surface parallel to a surface of the first Josephson junction and/or the first junction contact pad, the first circuit device element and/or the substrate.

The bridge center portion may be electrically and/or physically connecting the first and second bridge contact portion. The first and second bridge contact portions may be positioned on opposing ends of the bridge center portion.

The bridge center portion may extend along the whole lateral distance from the first Josephson junction and/or the first junction contact pad to the first circuit device element. The bridge center portion may be fully air-gapped from and/or suspended over the substrate.

The bridge center portion may be in the shape of an arc. The bridge center portion may comprise a flat middle portion extending substantially parallel (or coplanar) with the surface of the substrate. The bridge center portion may also comprise linearly sloped sidewalls connected to the first and second bridge contact portions.

A lateral width of the first air bridge may correspond to a lateral width of the first and/or second bridge contact portion and/or a lateral width of the bridge center portion. A lateral length of the first air bridge may correspond to the length of the bridge center portion or to the sum of a length of the bridge center portion, a length of the first bridge contact portion and a length of the second bridge center portion.

The overlap area and/or the physical contact area between the first air bridge and the first Josephson junction and/or the first junction contact pad may correspond to the overlap area and/or the physical contact area between the first bridge contact portion and the first Josephson junction and/or the first junction contact pad. The overlap area and/or the physical contact area between the first air bridge and the first circuit device element may correspond to the overlap area and/or the physical contact area between the second bridge contact portion and the first circuit device element.

The first Josephson junction and/or the first junction contact pad and the first air bridge may also be formed in a same lithographic process. The same lithographic process may comprise using a common resist for forming/depositing the first Josephson junction and/or the first junction contact pad and the first air bridge into openings of the common resist. The common resist may be the second resist for forming the first Josephson junction and/or the first junction contact pad. Additionally, or alternatively, the common resist may also correspond to the (third) resist for forming the first air bridge as explained further above.

Optionally, the same lithographic process comprises forming a common resist over and/or on the substrate. The same lithographic process may further comprise patterning the common resist.

The method or the patterning of the common resist may comprise forming first openings in the common resist and forming the first Josephson junction and/or the first junction contact pad in the first openings. The first openings may expose a portion of the surface of the substrate. The first openings may be or correspond to trenches formed in the common resist.

The method or the forming first openings in the common resist and forming the first Josephson junction and/or the first junction contact pad in the first openings may comprise forming an undercut in the resist and/or an overhang of the resist over the substrate and forming the first Josephson junction on the substrate under the overhang and/or in the undercut by using double-angle evaporation.

The same lithographic process may comprise forming at least one second opening in the common resist and forming the first air bridge in the second opening of the common resist. The second opening may expose at least a (contact) portion of the first Josephson junction, the first junction contact pad, the first circuit device element and/or the patterned base layer. The second opening may not expose a surface of the substrate (or any portion thereof).

The method or the forming the at least one second opening in the common resist and forming the first air bridge in the second opening of the common resist may comprise bringing at least a portion of the common resist into a bridge-like shape (without exposing the surface of the substrate). The bridge-like shape of the common resist may be formed by using grayscale electron beam lithography.

Features explained further above with respect to the resist for forming the first air bridge may equally apply to the common resist and vice versa.

The method may also further comprise forming at least one additional air bridge for establishing an electrical coupling between (disjunct) portions of the base layer. The additional air bridge may directly contact and couple (further) disjunct portions of the base layer. One of the disjunct portions contacted by the additional air bridge may be the first circuit device element. The disjunct portions of the base layer contacted by the additional air bridge may also be different (and disjunct) from the first circuit device element. The additional air bridge may be formed using the same third resist and/or the common resist as in the manufacturing of the first air bridge. Optionally, the additional air bridge may be formed in an additional opening of the third resist and/or the common resist. Further manufacturing steps may be carried out analogously. The length of the additional air bridge may be larger than the length of the first air bridge. A width of the additional air bridge may be larger than a width of the first air bridge. The additional air bridge may be used to improve the grounding and/or routing of the contacted disjunct portions of the base layer.

In general, the method or the patterning of a resist, e.g., the first, second, third or common resist, may comprise an exposure step of exposing a portion of said resist to a radiation source or an electron beam lithography tool. Said portion may correspond to an opening to be formed in the resist, e.g., a first and/or second opening. Additionally, or alternatively, said portion may correspond to a portion of the resist that is to be brought into a bridge-like shape.

The patterning of a resist may additionally comprise a baking step by exposing the device to an elevated temperature after the exposure step. The elevated temperature may be higher than 50 degree Celsius.

The patterning of a resist may additionally comprise a development step of using a developer or a developer composition to remove a portion of the resist exposed to a radiation source or an electron beam lithography tool, thereby forming an opening in the resist, e.g., the first and/or second openings, or forming the bridge-like shape.

Preferably, the developer is or comprises water and isopropyl alcohol (IPA). The percentage of IPA in the water may be in a range from 70 percent to 90 percent. This may prevent cracking of the resist during development.

Preferably, the common resist is or comprises a bilayer resist with a first resist layer and a second resist layer. The forming the common resist over the substrate may then comprise forming the first resist layer over or directly on the substrate and forming the second resist layer over or directly on the first resist layer.

Optionally, the first resist layer has a higher sensitivity and/or a lower contrast with respect to the developer used for patterning the common resist as compared to the second resist layer.

Optionally, the first resist layer is or comprises methyl methacrylate (MMA), a copolymer of MMA and/or methacrylic acid (MAA). Optionally, the second resist layer is or comprises polymethyl methacrylate (PMMA). Preferably, the second resist layer comprises polymethyl methacrylate with a molar mass of 950000 g/mol (PMMA 950k).

Optionally, the thickness of the common resist is equal or larger than 1 Micrometer. The thickness of the first resist layer may be smaller than the thickness of the second resist layer. The thickness of the second resist layer may be more than twice as higher as the thickness of the first resist layer

The first openings may be formed in the first and second resist layer. The at least one second opening may at least be formed in the second resist layer. The at least one second opening may expose a portion of the (surface of the) first resist layer.

The method or the patterning of the (common) resist may comprise forming an overhang of the second resist layer and/or an undercut of the first resist layer over the substrate for forming the first Josephson junction under the overhang and/or in the undercut, e.g., by using double-angle evaporation and/or shadow evaporation.

The method or the patterning of the (common) resist may comprise bringing at least a portion of the common resist and/or of the first resist layer into a bridge-like shape (without exposing the surface of the substrate), e.g., by using grayscale electron beam lithography. Specifically, the portion of the first resist layer exposed by the second opening may be brought into the bridge-like shape, e.g., by using grayscale electron beam lithography.

In a second aspect, the invention relates to a circuit device. The circuit device comprises a substrate, a first Josephson junction on the substrate, a first circuit device element on the substrate, and a first air bridge. The first circuit device element is spaced apart from the first Josephson junction. The first air bridge is extending from the first Josephson junction to the first circuit device element and bridging over a lateral distance between the first Josephson junction and the first circuit device element without making contact to the substrate to establish an electrical coupling between the first Josephson junction and the first circuit device element.

The circuit device may be manufactured using a method according to the first aspect or any variant thereof. The circuit device may be a quantum circuit device and/or a superconducting (quantum) circuit device. The circuit device may be used for quantum computing, quantum simulations and/or quantum sensing.

Optionally, the first circuit device element is a first conductive island and/or a portion of a patterned base layer on the substrate. The first circuit device element may also be a second Josephson junction in order to form an electrically coupled Josephson junction array on the substrate. The Josephson junction array may comprise at least the first Josephson junction and the second Josephson junction. The second Josephson junction may be configured in a similar manner as the first Josephson junction as described with respect to the first aspect or any variant thereof.

In a third aspect, the invention relates to a topological circuit device. The topological circuit device comprises a substrate; a first conductive island over the substrate; a second conductive island over the substrate and spaced apart from the first conductive island by a first lateral gap; a third conductive island over the substrate and spaced apart from the second conductive island by a second lateral gap, wherein the third conductive island is also spaced apart from the first conductive island by a third lateral gap; a first Josephson junction in the first lateral gap and on the substrate and electrically coupled to the first and second conductive island; and a second Josephson junction in the second lateral gap and on the substrate and electrically coupled to the second and third conductive island.

The topological circuit device further comprises a first air bridge extending from the first conductive island to the third conductive island and bridging over the third lateral gap and over a portion of the second conductive island in the third lateral gap without making contact to the substrate and without making contact to the portion of the second conductive island in the third lateral gap to establish an electrical coupling between the first conductive island and the third conductive island.

The first air bridge is part of a closed electrically conducting path extending from the first conductive island via the first air bridge to the third conductive island and from the third conductive island via the second Josephson junction, the second conductive island and the first Josephson junction back to the first conductive island.

The closed electrically conducting path thus has the shape of an "eight" (when projected onto the surface of the substrate), i.e., a twisted topology or the topology of a Möbius or Möbius-like strip. The topological circuit design has favorable noise properties since the formation of a closed electrically conducting path in the shape of an "eight" as described above reduces flux noise originating from global magnetic fields.

The topological circuit device may further comprise:
- a second air bridge extending from the second Josephson junction to the third conductive island to establish an electrical coupling between the second Josephson junction and the third conductive island without making contact to the substrate; and/or
- a third air bridge extending from the second Josephson junction to the second conductive island to establish an electrical coupling between the second Josephson junction and the second conductive island without making contact to the substrate; and/or
- a fourth air bridge extending from the first Josephson junction to the second conductive island to establish an electrical coupling between the first Josephson junction and the second conductive island without making contact to the substrate; and/or
- a fifth air bridge extending from the first Josephson junction to the first conductive island to establish an electrical coupling between the first Josephson junction and the first conductive island without making contact to the substrate.

The first conductive island, the second conductive island, the third conductive island may be disjunct, e.g., disjunct portions of a (patterned) base layer. The (patterned) base layer may be on or over the substrate.

The topological circuit device may further comprise a magnetic flux control unit and/or line configured to generate a magnetic flux through the closed electrically conducting path.

It is emphasized that features of the different aspects can be combined with one another. For example, features relating to the first Josephson junction, the first junction contact pad, the first air bridge, the first conductive island, first base layer portion, first resist etc introduced in relation to a certain aspect can be applied and combined with features of any (e.g., second, third etc) Josephson junction, junction contact pad, air bridge, conductive island, base layer portion, resist etc as introduced in any other aspect of the invention.

In summary, the proposed method enables an efficient and flexible manufacturing of circuit devices, in particular, quantum circuit devices, with suppressed noise and large coherence times. Moreover, the forming of an air bridge as coupling means for the Josephson junction can be efficiently integrated with the manufacturing of more conventional (and larger sized) air bridges, e.g., used as coupling means between otherwise disjunct portions of the base layer, e.g., for efficient grounding of interior portions of the base layer and/or further routing of signals. For example, air bridges fabricated with the same manufacturing method can also be used as crossovers to connect different elements on the base layer which are separated by a third element, e.g. crossing coplanar waveguide structures.

### Detailed Description

Exemplary embodiments of the invention are illustrated in the drawings and will now be described with reference to figures 1 to 7.

In the figures:
- Fig. 1: shows a schematic of a process flow for forming an air bridge,
- Fig. 2: shows a schematic of an embodiment of a circuit device comprising a base layer,
- Fig. 3: shows SEM images of an embodiment of a circuit device,
- Fig. 4: shows a schematic of a common resist,
- Fig. 5: shows a schematic of an embodiment of a circuit device comprising a Josephson junction array,
- Fig. 6: shows a schematic of an embodiment of a topological circuit device
- Fig. 7: shows an SEM image of an embodiment of an air bridge for base layer to base layer coupling.

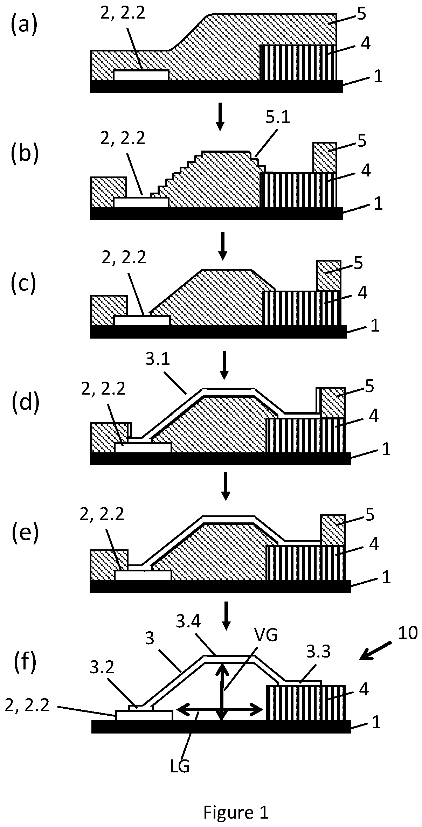

Figure 1 shows a schematic of a process flow for forming an air bridge 3. The process flow is part of the method of manufacturing a circuit device 10.

The method comprises forming a first Josephson junction 2 with a first junction contact pad on a substrate 1. The first junction contact pad 2.2 is an integrated portion of an electrode 2.2 of the first Josephson junction 2. The method further comprises forming a first air bridge 3 to establish an electrical coupling between the first Josephson junction 2 via the first junction contact pad 2.2 and a first circuit device element 4. The first circuit device element 4 is arranged on the substrate 1 and spaced apart from the first Josephson junction 2 and the first junction contact pad 2.2.

Panels (a)-(f) of Figure 1 show a process flow of the method related to the forming of the first air bridge 3 after the first Josephson junction 2 with the first junction contact pad 2.2 and the first circuit device element 4 were formed on the substrate 1.

In the embodiment shown in Figure 1 the first circuit device element 4 corresponds to a portion of a patterned base layer formed on the substrate 1. The base layer is made from Aluminum and has a thickness of 300 Nanometer. The portion of the patterned base layer corresponding to the first circuit device element 4 is a first conductive island. The base layer is patterned using photolithography with a first resist (not shown). The patterning of the base layer results in a lateral gap formed in the base layer that exposes a portion of the surface of the substrate 1 for forming the first Josephson junction 2 and the first junction contact pad 2.2 in the lateral gap on the exposed surface of the substrate 1.

After the forming and the patterning of the base layer and the removal of the first resist, the first Josephson junction 2 with the first junction contact pad 2.2 is formed in the lateral gap of the patterned base layer using photolithography with a second resist (not shown). In Figure 1, the first junction contact 2.2 pad corresponds to a portion of the bottom electrode 2.2 of the first Josephson junction 2. The first junction contact pad 2.2 is thus directly on the surface of the substrate 1 and has a thickness of 100 Nanometer.

After the removal of the second resist, another (third) resist 5 for forming the first air bridge 3 is deposited on the substrate 1, on the first circuit device 4 element and on the first Josephson junction 2 with the first junction contact 2.2 pad as shown in Panel (a) of Figure 1. The resist 5 for forming the air bridge 2 is a PMMA resist with a thickness of 1 Micrometer.

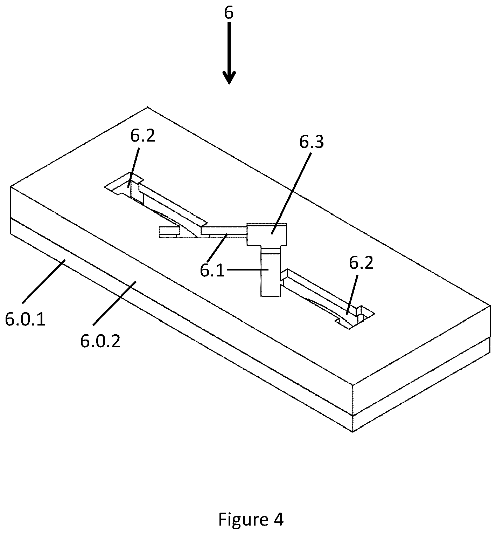

In the following discussion of Figure 1, when referring to a resist we refer to the resist 5 for forming the air bridge 3 as shown in Figure 1 (and not to the first resist for forming the patterned base layer and not to the second resist for forming the first Josephson junction 2; first and second resist are not shown in Figure 1). Note, that in this embodiment the resist 5 for forming the air bridge 3 is different from the resist for forming the first Josephson junction 2 with the first junction contact pad 2.2. In another embodiment, e.g., as shown in Figure 4, the second resist and the resist 5 for forming the air bridge 2 may be the same common resist 5, 6.

After forming the resist 5, the resist 5 for forming the first air bridge 3 undergoes patterning as shown in panel (b) of Figure 1. The patterning comprises forming openings in the resist 5. Said openings expose at least a portion of the surface of the first junction contact pad 2.2 and the first circuit device element 4. The patterning further comprises bringing at least a portion of the resist 5 into a bridge-like shape 5.1 without exposing the surface of the substrate 1 by using grayscale electron beam lithography. The bridge-like shape 5.1 of the resist 5 may also be referred to as a scaffold 5.1 for the to-be-deposited first air bridge 3. Grayscale electron beam lithography as opposed to conventional binary electron beam lithography comprises varying the dose of the electron beam along the surface of the resist 5 to achieve different height levels in the patterned resist 5 (after development), e.g., different height levels of the bridge-like shape 5.1. This results in the bridge-like shape 5.1 having the form of or comprising a staircase.

More specifically, the patterning comprises an exposure step, a baking step and a development step.

The exposure step comprises exposing at least one portion of the resist 5 to an electron beam generated by an electron beam lithography tool and performing grayscale electron beam lithography with varying electron beam dose along the surface of the resist 5 to achieve a spatially varying energy transfer to the resist which later (after development) results in a bridge-like shape 5.1 of the resist with varying heights, i.e., a staircase profile of the bridge-like 5.1 shape as shown in panel (b).

After the exposure step, a baking step is carried out. The baking step comprises baking the sample shown at an elevated temperature of 60 degrees Celsius for 180 seconds.

After the exposure and baking steps, a development step is carried out. The development step comprises developing the sample using an appropriate developer, i.e. a developer composition. In this example, a developer comprising methyl isobutyl ketone (MBIK) and IPA was used with a mass ratio of MBIK:IPA=3:1. Panel (b) then shows the result of the development step.

The method further comprises a reflow step for smoothing the staircase-like surface of the bridge-like shape 5.1 of the resist 5. In the reflow step, the sample shown in panel (b) is reflowed on a hotplate at a further elevated temperature of 130 degrees Celsius for 45 seconds. Panel (c) shows the result of the reflow step with the staircase profile being smoothed into sloped sidewalls of the bridge-like shape 5.1.

Next, the sample is positioned in an electron beam metal evaporator equipped with an ion milling gun. Note, that the cleaning and deposition step are being carried out subsequently without breaking the vacuum in between.

The method further comprises a cleaning step for cleaning the exposed portions of the surface of the first Josephson junction 2, i.e., the surface of the first junction contact pad 2.2, and the first circuit device element 4 from metal oxides by using ion milling. This considerably improves the electrical contact when subsequently depositing conductive material 3.1 for forming the air bridge 3 in a next step and also increases adhesion and mechanical stability of the sample.

After ion milling a deposition step is carried out as shown in panel (d) of Figure 1. The deposition step comprises depositing a conductive material 3.1 on the bridge-like shape 5.1 to form the air bridge 3. Specifically, Aluminum is deposited as the conductive material 3.1. The thickness of the conductive material 3.1 layer is 450 Nanometer. Note, that various layer thicknesses in Figure 1 are not necessarily shown in appropriate relative scales/dimensions.

The result of the deposition step is shown in panel (d) and comprises the conductive material 3.1 being also deposited on the sidewalls of the (patterned) resist 5 in the openings/trenches that expose the surface of the first Josephson junction 2 and the first junction contact pad 2.2 and the first circuit device element 4. In order to remove the unwanted sidewall portions of the conductive material layer 3.1 an etching step is performed. The etching step comprises wet etching the sample shown in panel (d) to remove the unwanted sidewall portions. The result of the wet etching is shown in panel (e) of Figure 1.

The method further comprises a lift-off step. The lift-off step comprises exposing the sample shown in panel (e) to acetone overnight. As a result of the lift-off step, the remaining portions of the resist 5, in particular the remaining portions of the resist 5 between the substrate 1 and the conductive material layer 3.1, are being removed as shown in panel (f) of Figure 1. As a result of the deposition and/or the lift-off step, it may be considered that the first air bridge 3 is formed and freely suspending over the substrate 1.

The first air bridge 3 bridges over a lateral gap LG reaching/extending from the first junction contact pad 2.2 to the first circuit device element 4 without making contact to the substrate 1. The first air bridge 3 comprises a bridge center portion 3.4 and a first bridge contact portion 3.2 and a second bridge contact portion 3.3 connected to the bridge center portion 3.4 on opposing ends of the bridge center portion 3.4.

In particular, the first air bridge 3 is fully gapped from the substrate by a vertical gap VG extending from the surface of the substrate 1 to a surface of the first air bridge 3 facing the surface of the substrate 1. The vertical gap VG is equal or larger than the thickness of the first junction contact pad 2.2. The minimum of the vertical gap VG corresponds to the thickness of the first junction contact pad 2.2, i.e., a thickness of the first Josephson junction 2. The maximum of the vertical gap VG is an air gap. The maximal vertical air gap VG is larger than the thickness of the first circuit device element 4. In the embodiment shown in Figure 1, the maximal vertical (air) gap VG is 500 Nanometers.

Recurring features are provided in the following figures with identical reference signs as in Figure 1.

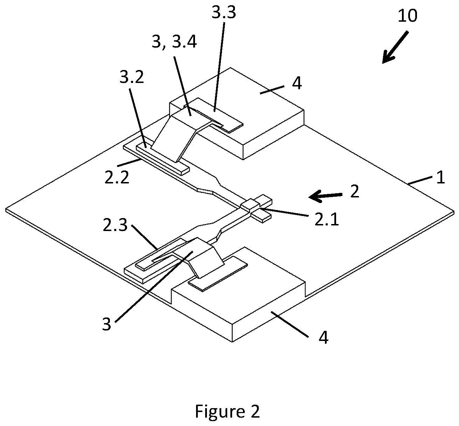

Figure 2 shows a schematic of an embodiment of a circuit device 10 comprising a base layer. Specifically, Figure 2 shows a top view of the first Josephson junction 2, the first junction contact pad 2.2 and the first circuit device element 4. It is noted that panel (f) of Figure 1 corresponds to a cross section view through the circuit device 10 shown in Figure 2.

The first Josephson junction 2 comprises a top electrode layer 2.3, a bottom electrode layer 2.2 and a tunnel barrier layer between top and bottom electrode in the respective overlap region 2.1. Each of the bottom electrode layer 2.2 and the top electrode layer 2.3 comprise a junction overlap portion in the overlap region 2.1 and an electrode extension portion being elongated and pointing away from the overlap region 2.1. The electrode extension portions of the top and bottom electrode form a right angle. The top and bottom electrode, in particular each one of the electrode extension portions, are tapered towards the overlap region 2.1 and the tunnel barrier layer of the first Josephson junction 2. In particular, a width of the first junction contact pad 2.2 and the extension portions of the top and bottom electrodes away from the overlap region 2.1 is larger than a width of the overlap portions of the bottom and top electrodes and of the extension portions near the overlap region 2.1. This ensure sufficient contact area for making good electrical contact between the first junction contact pad 2.2 and the first air bridge 3.

The first junction contact pad 2.2 is an integrated part of the extension portion of the bottom electrode 2.2 and thus of the bottom electrode 2.2 itself. Thus, the first air bridge 3 electrically and physically connects to the bottom electrode 2.2 and the first junction contact pad 2.2 and couples the bottom electrode 2.2 to the first circuit device element 4 being a first conductive island of the patterned base layer.

Additionally, the first Josephson junction 2 also comprises a second junction contact pad 2.3 as portion of the top electrode 2.3, i.e., as part of the extension portion of the top electrode 2.3.

The circuit device 10 also comprises a second circuit device element 4 on the substrate 1 spaced apart from the first Josephson junction 2, the first circuit device element 4 and the second junction contact pad 2.3. The second circuit device element 4 corresponds to another portion of the patterned base layer that is spaced apart and disjunct from the first circuit device element 4, i.e., a second conductive island.

The circuit device 10 also comprises a second air bridge 3 extending from the first Josephson junction 2 and the second junction contact pad 2.3 (top electrode) to the second circuit device element 4 and bridging over a lateral distance/gap between the second junction contact pad 2.3 and the second circuit device element 4 without making contact to the substrate 1 to establish an electrical coupling/connection between the first Josephson junction 2 via the second junction contact pad 2.3 and the second circuit device element 4. Thus, the second air bridge 3 electrically and physically connects to the top electrode 2.3 and couples the top electrode 2.3 to the second circuit device element 4 being a second conductive island of the patterned base layer. The second air bridge 3 is manufactured simultaneously with and in a same manner as the first air bridge 3 as explained with respect to Figure 1.

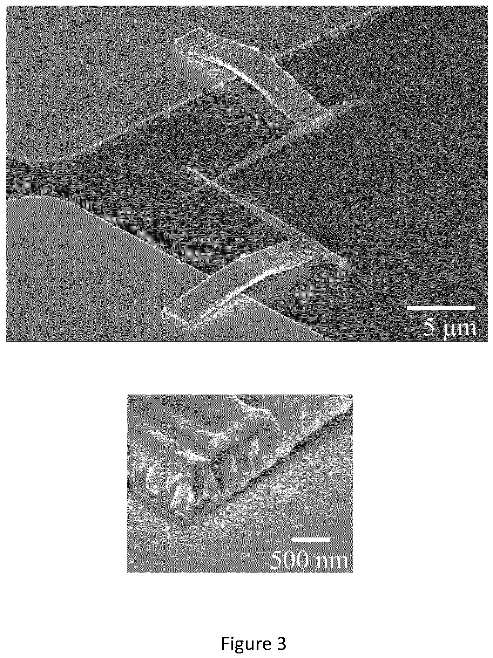

Figure 3 shows scanning electron microscope (SEM) images of another embodiment of a circuit device 10. The upper panel of Figure 3 shows a top view of first circuit device element 4. The rig lower panel shows a zoom into the overlap and physical contact area between the first air bridge 3 and the first circuit device element 4.

The length of the first junction contact pad 2.2 along the length direction of the first air bridge 3, i.e., in a direction pointing towards the first circuit device element 4, is approximately only 500 Nanometers. The length of the second junction contact pad 2.3 in the length direction of the second air bridge 3, i.e., in a direction pointing towards the second circuit device element 4, is also only 500 Nanometers. A lateral width of the first and second air bridge 3 is about 2 Micrometer resulting in a very small overlap and physical contact area between the first/second air bridge 3 and the respective junction contact pad 2.2, 2.3.

Such narrow air bridges 3 facilitate an efficient cleaning with ion milling due to less resist sticking beneath the air bridge 3. Moreover, finer air bridges 3 reduce the probability of exposing the substrate 1 during ion milling. In particular, the removal of the remaining resist 5 after the depositing of the conductive material layer 3.1 is more efficient.

Figure 4 shows a schematic of a common resist 6 as being used in an alternative embodiment of the method for manufacturing a circuit device 10.

In the alternative embodiment, the first Josephson junction 2, the first junction contact pad 2.2 and the first air bridge 3 are formed in a same lithographic process. The same lithographic process comprises forming the common resist 6 on the substrate 1 and on the patterned base layer (not shown in Figure 4).

The common resist 6 is a bilayer resist with a first resist layer 6.0.1 and a second resist layer 6.0.2. The method comprises forming the first resist layer 6.0.1 directly on the substrate 1 and forming the second resist layer 6.0.2 directly on the first resist layer 6.0.1. The first resist layer 6.0.1 comprises a copolymer of methyl methacrylate (MMA) and methacrylic acid (MAA). The second resist layer 6.0.2 is polymethyl methacrylate (PMMA).

The method comprises patterning the common resist 6 by forming first openings 6.1 in the form of two trenches in the common resist 6 for forming the first Josephson junction 2. The two trenches expose a portion of the surface of the substrate 1 and form a right angle on the surface of the substrate 1. The method further comprises forming an undercut of the first resist layer 6.0.1 under the second resist layer 6.0.2, thereby forming an overhang 6.3 of the second resist layer 6.3 extending over the first resist layer 6.0.1 and the substrate 1. The method further comprises forming the first Josephson junction 2 in the first openings 6.1 on the substrate 1 with the tunnel junction area 2.1 being placed under the overhang 6.3 using double-angle and shadow evaporation. The method further comprises forming a second opening 6.2 in the form of a trench in the common resist 6 for forming the first air bridge 3. The second opening 6.2 exposes a surface of the first circuit device element 4 but does not expose the surface of the substrate 1. A portion of the first resist layer 6.0.1 is brought into a bridge-like shape 5.1 by using grayscale electron beam lithography.

The method further comprises forming another second opening 6.2 in the form of a trench in the common resist 6 for forming the second air bridge 3. The another second opening 6.2 exposes a surface of the second circuit device element 4 but does not expose the surface of the substrate 1. Another portion of the first resist layer 6.0.1 is brought into a bridge-like shape 5.1 by using grayscale electron beam lithography.

The method then comprises forming the first air bridge 3 in the second opening 6.2 and forming the second air bridge 3 in the another second opening 6.2 by depositing the conductive material layer 3.1 using shadow evaporation. The conductive material layer 3.1 is deposited on the bridge-like shaped portions 5.1 of the first resist layer 6.0.1. The conductive material layer 3.1 is also deposited on the exposed surface of the first and second junction contact pads 2.3, 2.3 and the first and second circuit device element 4.

The method further comprises a cleaning step for cleaning the exposed portions of the surface of the first Josephson junction 2, e.g., the surface of the first junction contact pad 2.2, and the first circuit device element 4 from metal oxides by using ion milling as outlined further above. Here, the cleaning step be carried out after the forming the first Josephson junction 2 in the first openings 6.1 before the deposition of the conductive material layer 3.1 for forming the first air bridge 3.

The method also comprises removing the common resist 6 to obtain the circuit device 10.

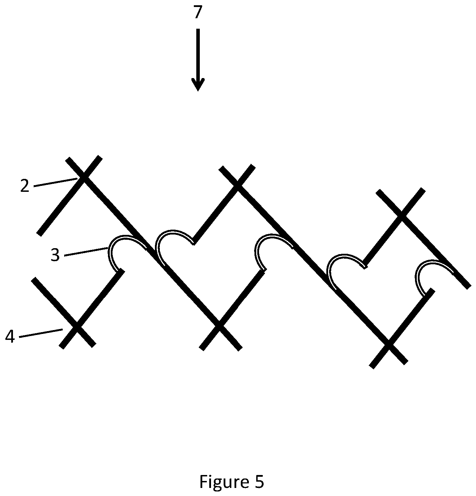

Figure 5 shows a schematic of an embodiment of a circuit device 10 comprising a Josephson junction array. The circuit device 10 is a variant of the circuit devices 10 shown in Figures 1 to 3 with the exception that the first circuit device element 4 is not a portion of the base layer, but a second Josephson junction 4. In this way, a Josephson junction array is formed comprising the first 2 and second 4 Josephson junction. The first air bridge 3 then couples the first 2 and second 4 Josephson junction. The Josephson junction array shown in Figure 5 comprises six Josephson junctions coupled by four air bridges. The Josephson junction array may be further electrically coupled to a patterned base layer (not shown in Figure 5) for further routing and/or grounding. The further couplings may be realized in a conventional manner or in a manner as described with respect to Figures 1 to 3, i.e., by coupling the Josephson junctions to at least a portion of the patterned base layer using additional air bridges.

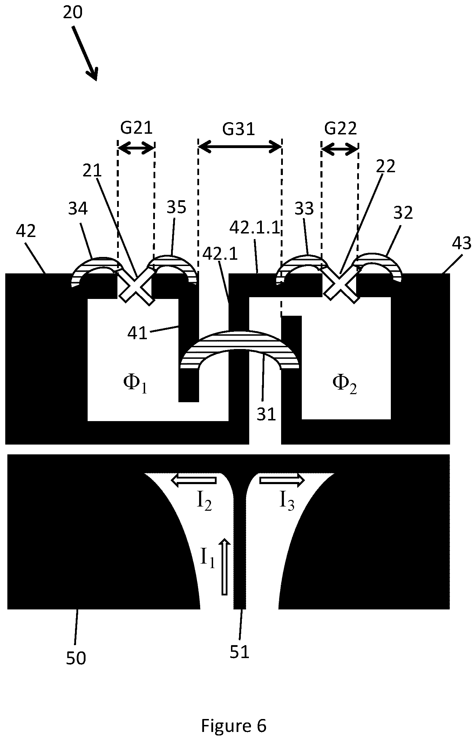

Figure 6 shows a topological circuit device 20 in a top view.

The topological circuit device 20 comprises a substrate (not shown). The topological circuit device 20 further comprises a first conductive island 41 over the substrate; a second conductive island 42 over the substrate, wherein the second conductive island 42 is spaced apart from the first conductive island 41 by a first lateral gap G21, a third conductive island 43 over the substrate, wherein the third conductive island 43 is spaced apart from the second conductive island 42 by a second lateral gap G22. The first conductive island 41, the second conductive island 42 and the third conductive island 43 are each disjunct portions of a patterned metallic base layer on the substrate. The third conductive island 43 is also spaced apart from the first conductive island 41 by a third lateral gap G31.

The second conductive island 42 comprises a main portion and an extension portion 42.1 that are directly (and continuously) connected and non-disjunct. The extension portion 42.1 is positioned in the third lateral gap G31, i.e., between the first 41 and the third 43 conductive island, and passes through the third lateral gap G31. The extension portion 42.1 is thus disjunct and spaced apart from the first 41 and the third 43 conductive island. The second lateral gap G22 is a gap between the extension portion 42.1 of the second conductive island 42 and the third conductive island 43. Specifically, the second lateral gap G22 is a gap between the third conductive island 43 and an end portion 42.1.1 of the extension portion 42.1 of the second conductive island 42, wherein the end portion 42.1.1 extends outside the third lateral gap G31 towards the second Josephson junction 22.

A first Josephson junction 21 is positioned in the first lateral gap G21 and on the substrate. The first Josephson junction 21 is electrically coupled to the first 41 and second 42 conductive island by first coupling means. Here, the first coupling means are air bridges 34, 35, i.e., the fourth 34 and fifth 35 airbridge as discussed further below. In an alternative embodiment, the first coupling means may also be conventional coupling means, e.g., bandages on the substrate.

A second Josephson junction 22 is positioned in the second lateral gap G22 and on the substrate. The second Josephson junction 22 is electrically coupled to the second 42 and third 43 conductive island. Specifically, the second Josephson junction 22 is coupled to the extension portion 42.1 that extends through the second lateral gap G22. More specifically, the second Josephson junction 22 is coupled to the end portion 42.1.1 of the extension portion 42.1. The second Josephson junction 22 is electrically coupled to the second 42 and third 43 conductive island by second coupling means. Here, the second coupling means are air bridges 32, 33, i.e., the second 32 and third 33 airbridge as discussed further below. In an alternative embodiment, the second coupling means may also be conventional coupling means, e.g., bandages on the substrate.

The topological circuit device 20 further comprises a first air bridge 31 extending from the first conductive island 41 to the third conductive island 43 and bridging over the third lateral gap G31 and over the extension portion 42.1 of the second conductive island 42 that is passing through the third lateral gap G31 without making (physical) contact to the substrate and without making (physical) contact to the extension portion 42.1 of the second conductive island 42 in the third lateral gap G31. Thus, the first air bridge 31 establishes an electrical coupling between the first conductive island 41 and the third conductive island 43. Specifically, the first air bridge 31 directly physically connects to the first conductive island 41 and the third conductive island 43.

In particular, the first air bridge 31 is part of a closed electrically conducting path extending from the first conductive island 41 via the first air bridge 31 to the third conductive island 43 and from the third conductive island 43 via the second Josephson junction 22 (and the second coupling means 32, 33), the second conductive island 42 and the first Josephson junction 21 (and the coupling means 34, 35) back to the first conductive island 41. The closed electrically conducting path has a twisted topology, i.e., the topology of a Möbius strip.

The topological circuit device 20 has favorable noise properties due to its special topology. In particular, the topological circuit device 20 exhibits robustness and resilience with respect to magnetic flux noise.

The closed electrically conducting path comprises a first path portion and a second path portion. Each of the first and second path portions comprise an air-filled closed loop. Each of the first and second path portions form a closed loop (e.g., when projected on the surface of the substrate).

The first conductive island 41, the second conductive island 42, the first Josephson junction 21 and the first coupling means 34, 35 form a first air-filled (almost closed) loop (e.g., when projected onto the surface of the substrate in a top view).

The third conductive island 43, the extension portion 42.1 and/or the end portion 42.1.1 of the extension portion 42.1, the second Josephson junction 22, and the second coupling means 32, 33 form a second air-filled (almost closed) loop (e.g., when projected onto the surface of the substrate in a top view).

The first air-filled loop has (at least approximately) the same size as the second air-filled loop. The first air-filled loop is the first path portion, the second air-filled loop is the second path portion.

The topological circuit device 20 and/or the closed electrically conducting path are/is thus configured such that two loops, i.e., the first and second path portions, are formed (when projected onto a surface of the substrate). The two loops may be configured together as a Figure-8 loop. When a current is induced and starts flowing in a particular section of the closed electrically conducting path and flows once along the entire closed path, the current will traverse the two loops in opposite directions (i.e., one loop, e.g., the first path portion is circulated clockwise, the other loop, e.g., the second path portion, is circulated counter-clockwise).

Ambient magnetic noise sources (e.g. on or near the substrate) may generate a magnetic flux that penetrates the two loops in a same direction and may thus induce one current in the first air-filled loop and another current in the second air-filled loop. These two currents that stem from the same noise source may cancel each other nearly completely due to the described twisted Möbius strip topology of the electrically conducting path, thereby suppressing flux noise and improving the coherence times of the topological circuit device.

The topological circuit device 20 further comprises a magnetic flux control unit 50, e.g., comprising a magnetic flux line 51, configured to generate a magnetic flux through the closed electrically conducting path. The magnetic flux comprises a first magnetic flux Φ₁ and a second magnetic flux Φ₂.

Specifically, the magnetic flux control unit 50 is configured to generate the first magnetic flux Φ₁ through (e.g., an air-filled portion of) the first path portion and the second magnetic flux Φ₂ through (e.g., an air-filled portion of) the second path portion. The direction of the first magnetic flux Φ₁ is opposite to the direction of the second magnetic flux Φ₂. Therefore, the respective currents induced in the closed electrically conducting path will add up and generate a total current. The total current can then be used to control the topological circuit device 20.

More specifically, the magnetic flux line 51 is split into a first magnetic flux line portion and a second magnetic flux line portion. In particular, the magnetic flux line 51 is configured such that a current *I*₁ flowing in the magnetic flux line 51 will be split into a first current *I*₂ flowing along the first magnetic flux line portion and a second current *I*₃ flowing along the second magnetic flux line portion. The direction of the first current *I*₂ is opposite to the direction of the second current *I*₃. Thus, the first magnetic flux line portion and the first current *I*₂ are configured to generate the first magnetic flux Φ₁, the second magnetic flux line portion and the second current *I*₃ are configured to generate the second magnetic flux Φ₂ and the first and second magnetic flux are in opposite direction.

The topological circuit device further comprises:
- a second air bridge 32 extending from the second Josephson junction 22 to the third conductive island 43 to establish an electrical coupling between the second Josephson junction 22 and the third conductive island 43 without making contact to the substrate; specifically, the second air bridge 32 physically connects to the second Josephson junction 22 and to the third conductive island 43;
- a third air bridge 33 extending from the second Josephson junction 22 to the second conductive island 42 to establish an electrical coupling between the second Josephson junction 22 and the second conductive island 42 without making contact to the substrate; specifically, the third air bridge 33 physically connects to the second Josephson junction 22 and to the second conductive island 42, i.e., the extension portion 42.1 and the end portion 42.1.1 of the extension portion 42.1;
- a fourth air bridge 34 extending from the first Josephson junction 21 to the second conductive island 42 to establish an electrical coupling between the first Josephson junction 21 and the second conductive island 42 without making contact to the substrate; specifically, the fourth air bridge 34 physically connects to the first Josephson junction 21 and to the second conductive island 42;
- a fifth air bridge 35 extending from the first Josephson junction 21 to the first conductive island 41 to establish an electrical coupling between the first Josephson junction 21 and the first conductive island 41 without making contact to the substrate; specifically, the fifth air bridge 35 physically connects to the first Josephson junction 21 and to the first conductive island 41.

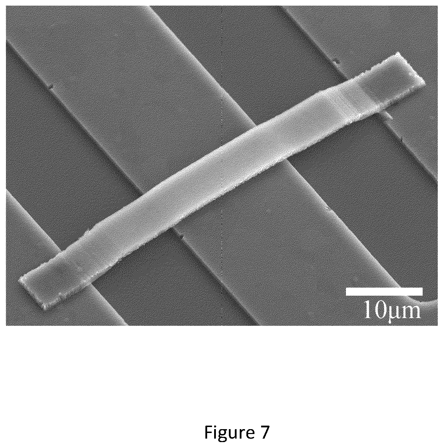

Figure 7 shows an SEM image of an embodiment of an air bridge 31 for base layer to base layer coupling. The air bridge 31 shown in Figure 7 corresponds to the first air bridge 31 shown schematically in Figure 6. The first air bridge 31 shown in Figures 6 and 7 has been manufactured with the same method of manufacturing as described with respect to Figures 1 and 2 with the difference that here the first air bridge 31 establishes electrical coupling between two conductive islands as portions of the patterned base layer rather than a coupling to a Josephson junction. The first air bridge 31 shown in Figures 6 and 7 is also substantially larger with a width larger than 5 Micrometer and a length larger than 50 Micrometer as compared to the first air bridge 3 for establishing contact to the first/second Josephson junction 2 shown in Figures 1, 2 and 3 or the second 32, third 33, fourth 34 and/or fifth 35 air bridge in Figures 6 and 7 for establishing contact to the first/second Josephson junction 21, 22. However, it is important to note that with the proposed method of manufacturing both air bridges can be manufactured in the same lithographic process using the same resist despite its size differences. The first air bridge 31 shown in Figures 6 and 7 may also be referred to another first air bridge 31 for better distinguishability.

Features of the different embodiments which are merely disclosed in the exemplary embodiments as a matter of course can be combined with one another and can also be claimed individually.

## Claims

1. A method of manufacturing a circuit device, the method comprising:
forming a first Josephson junction (2) on a substrate (1);
forming a first air bridge (3) to establish an electrical coupling between the first Josephson junction (2) and a first circuit device element (4), wherein the first circuit device element (4) is arranged on the substrate (1) and spaced apart from the first Josephson junction (2); and
wherein the first air bridge (3) bridges over a lateral gap extending from the first Josephson junction (2) to the first circuit device element (4) without making contact to the substrate (1).

2. The method according to the previous claim, wherein the first air bridge (3) is completely gapped from the substrate by a vertical gap larger or equal to a thickness of the first Josephson junction (2) and/or a thickness of the first circuit device element (4).

3. The method according to the previous claim, wherein the forming the first air bridge (3) comprises
forming a resist (5) on the substrate (1) for forming the first air bridge (3);
patterning the resist (5), wherein the patterning the resist (5) comprises
bringing a portion of the resist (5) into a bridge-like shape (5.1) by using grayscale electron beam lithography without exposing the surface of the substrate (1);
depositing a conductive material on the bridge-like shape (5.1) to form the first air bridge (3).

4. The method according to claim 3, wherein the patterning the resist (5) further comprises:
exposing at least a portion of the surface of the first circuit device element (4) and/or the first Josephson junction (2); and
cleaning the exposed surface of the first circuit device element (4) and/or of the first Josephson junction (2) using ion milling before depositing the conductive material on the bridge-like shape (5.1) to form the first air bridge (3).

5. The method according to any previous claim, wherein
a lateral width of the first air bridge (3) is smaller than 5 Micrometer;
and/or
an overlap area between the first air bridge (3) and the first Josephson junction (2) has a lateral width smaller than 1 Micrometer.

6. The method according to any previous claim, the method further comprising:
forming a base layer on the substrate (1) and patterning the base layer, wherein the patterning the base layer comprises
exposing a portion of the surface of the substrate (1) by forming a lateral gap in the base layer; and
the forming a first Josephson junction (2) on the substrate (1) comprises forming the first Josephson junction (2) in the lateral gap on the exposed surface of the substrate (1).

7. The method according to claim 6, wherein the patterning the base layer further comprises
forming a first conductive island as a portion of the patterned base layer, wherein the first conductive island of the patterned base layer is the first circuit device element (4).

8. The method according to claim 6 or 7, wherein the patterning the base layer further comprises
forming a first alignment marker as a portion of the patterned base layer, wherein the first alignment marker is indicative of the position of a first contact area (2.1) of the first Josephson junction (2) for enabling alignment of the first contact area (2.1) and the first air bridge (3) during forming the first air bridge (3).

9. The method according to any previous claim, wherein
the first Josephson junction (2) and the first air bridge (3) are formed in a same lithographic process, and wherein the same lithographic process comprises:
forming a common resist (5, 6) over the substrate (1) and patterning the common resist (5, 6), wherein the patterning the common resist (5, 6) comprises:
forming first openings (6.1) in the common resist (5, 6) and forming the first Josephson junction (2) in the first openings (6.1); and
forming at least one second opening (6.2) in the common resist (5, 6) and forming the first air bridge (3) in the at least one second opening (6.2) of the common resist (5, 6).

10. The method according to claim 9, wherein
the forming first openings (6.1) in the common resist (5, 6) and forming the first Josephson junction (2) in the first openings (6.1) comprises:
forming an overhang (6.3) of the resist (5, 6) and forming the first Josephson junction (2) under the overhang (6.3) by using double-angle evaporation;
and/or
the forming at least one second opening (6.2) in the common resist (5, 6) and forming the first air bridge (3) in the at least one second opening (6.2) of the common resist (5, 6) comprises:
bringing a portion of the common resist (5, 6) into a bridge-like shape 5.1) by using grayscale electron beam lithography without exposing the surface of the substrate (1).

11. A circuit device (10) comprising:
a substrate (1);
a first Josephson junction (2) on the substrate (1);
a first circuit device element (4) on the substrate (1) and spaced apart from the first Josephson junction (2);
a first air bridge (3) extending from the first Josephson junction (2) to the first circuit device element (4) and bridging over a lateral distance between the first Josephson junction (2) and the first circuit device element (4) without making contact to the substrate (1) to establish an electrical coupling between the first Josephson junction (2) and the first circuit device element (4).

12. The circuit device (10) according to claim 11, wherein
the first circuit device element (4) is a portion of a patterned base layer on the substrate (1);
or
the first circuit device element (4) is a second Josephson junction, wherein the the first Josephson junction (2) and the second Josephson junction form a Josephson junction array (7).

13. A topological circuit device (20) comprising:
a substrate (1);
a first conductive island (41) over the substrate (1);
a second conductive island (42) over the substrate (1) and spaced apart from the first conductive island (41) by a first lateral gap (G21);
a third conductive island (43) over the substrate (1) and spaced apart from the second conductive island (42) by a second lateral gap (G22), wherein the third conductive island (43) is also spaced apart from the first conductive island (41) by a third lateral gap (G31);
a first Josephson junction (21) in the first lateral gap (G21) and on the substrate (1) and electrically coupled to the first (41) and second (42) conductive island;
a second Josephson junction (22) in the second lateral gap (G22) and on the substrate (1) and electrically coupled to the second (42) and third (43) conductive island;
a first air bridge (31) extending from the first conductive island (41) to the third conductive island (43) and bridging over the third lateral gap (G31) and over a portion (42.1) of the second conductive island (42) in the third lateral gap (G31) without making contact to the substrate (1) and without making contact to the portion (42.1) of the second conductive island (42) in the third lateral gap (G31) to establish an electrical coupling between the first conductive island (41) and the third conductive island (43), wherein
the first air bridge (31) is part of a closed electrically conducting path extending from the first conductive island (41) via the first air bridge (31) to the third conductive island (43) and from the third conductive island (43) via the second Josephson junction (22), the second conductive island (42, 42.1) and the first Josephson junction (21) back to the first conductive island (41).

14. The topological circuit device according to claim 13 further comprising:
a second air bridge (32) extending from the second Josephson junction (22) to the third conductive island (43) to establish an electrical coupling between the second Josephson junction (22) and the third conductive island (43) without making contact to the substrate (1); and/or
a third air bridge (33) extending from the second Josephson junction (22) to the second conductive island (42) to establish an electrical coupling between the second Josephson junction (22) and the second conductive island (42) without making contact to the substrate (1); and/or
a fourth air bridge (34) extending from the first Josephson junction (21) to the second conductive island (42) to establish an electrical coupling between the first Josephson junction (21) and the second conductive island (42) without making contact to the substrate (1); and/or
a fifth air bridge (35) extending from the first Josephson junction (21) to the first conductive island (41) to establish an electrical coupling between the first Josephson junction (21) and the first conductive island (41) without making contact to the substrate (1).

15. The topological circuit device according to claim 13 or 14 further comprising a magnetic flux control unit (50) configured to generate a magnetic flux through the closed electrically conducting path.

## Amended claims

### Amended claims in accordance with Rule 137(2) EPC.

1. A method of manufacturing a circuit device, the method comprising:
forming a first Josephson junction (2) on a substrate (1);
forming a first air bridge (3) to establish an electrical coupling between the first Josephson junction (2) and a first circuit device element (4), wherein the first circuit device element (4) is arranged on the substrate (1) and spaced apart from the first Josephson junction (2) by a lateral gap;
**characterized in that**
the first air bridge (3) bridges over the entire lateral gap extending from the first Josephson junction (2) to the first circuit device element (4) without making any contact to the substrate (1).

2. The method according to the previous claim, wherein the first air bridge (3) is completely gapped from the substrate by a vertical gap larger or equal to a thickness of the first Josephson junction (2) and/or a thickness of the first circuit device element (4).

3. The method according to the previous claim, wherein the forming the first air bridge (3) comprises
forming a resist (5) on the substrate (1) for forming the first air bridge (3);
patterning the resist (5), wherein the patterning the resist (5) comprises
bringing a portion of the resist (5) into a bridge-like shape (5.1) by using grayscale electron beam lithography without exposing the surface of the substrate (1);
depositing a conductive material on the bridge-like shape (5.1) to form the first air bridge (3).

4. The method according to claim 3, wherein the patterning the resist (5) further comprises:
exposing at least a portion of the surface of the first circuit device element (4) and/or the first Josephson junction (2); and
cleaning the exposed surface of the first circuit device element (4) and/or of the first Josephson junction (2) using ion milling before depositing the conductive material on the bridge-like shape (5.1) to form the first air bridge (3).

5. The method according to any previous claim, wherein
a lateral width of the first air bridge (3) is smaller than 5 Micrometer; and/or
an overlap area between the first air bridge (3) and the first Josephson junction (2) has a lateral width smaller than 1 Micrometer.

6. The method according to any previous claim, the method further comprising:
forming a base layer on the substrate (1) and patterning the base layer, wherein the patterning the base layer comprises
exposing a portion of the surface of the substrate (1) by forming a lateral gap in the base layer; and
the forming a first Josephson junction (2) on the substrate (1) comprises forming the first Josephson junction (2) in the lateral gap on the exposed surface of the substrate (1).

7. The method according to claim 6, wherein the patterning the base layer further comprises
forming a first conductive island as a portion of the patterned base layer, wherein the first conductive island of the patterned base layer is the first circuit device element (4).

8. The method according to claim 6 or 7, wherein the patterning the base layer further comprises
forming a first alignment marker as a portion of the patterned base layer, wherein the first alignment marker is indicative of the position of a first contact area (2.1) of the first Josephson junction (2) for enabling alignment of the first contact area (2.1) and the first air bridge (3) during forming the first air bridge (3).

9. The method according to any previous claim, wherein
the first Josephson junction (2) and the first air bridge (3) are formed in a same lithographic process, and wherein the same lithographic process comprises:
forming a common resist (5, 6) over the substrate (1) and patterning the common resist (5, 6), wherein the patterning the common resist (5, 6) comprises:
forming first openings (6.1) in the common resist (5, 6) and forming the first Josephson junction (2) in the first openings (6.1); and
forming at least one second opening (6.2) in the common resist (5, 6) and forming the first air bridge (3) in the at least one second opening (6.2) of the common resist (5, 6).

10. The method according to claim 9, wherein
the forming first openings (6.1) in the common resist (5, 6) and forming the first Josephson junction (2) in the first openings (6.1) comprises:
forming an overhang (6.3) of the resist (5, 6) and forming the first Josephson junction (2) under the overhang (6.3) by using double-angle evaporation;
and/or
the forming at least one second opening (6.2) in the common resist (5, 6) and forming the first air bridge (3) in the at least one second opening (6.2) of the common resist (5, 6) comprises:
bringing a portion of the common resist (5, 6) into a bridge-like shape 5.1) by using grayscale electron beam lithography without exposing the surface of the substrate (1).

11. A circuit device (10) comprising:
a substrate (1);
a first Josephson junction (2) on the substrate (1);
a first circuit device element (4) on the substrate (1) and spaced apart from the first Josephson junction (2) by a lateral gap;
a first air bridge (3) extending from the first Josephson junction (2) to the first circuit device element (4);
**characterized in that**
the first air bridge (3) is bridging over the entire lateral gap between the first Josephson junction (2) and the first circuit device element (4) without making any contact to the substrate (1) to establish an electrical coupling between the first Josephson junction (2) and the first circuit device element (4).

12. The circuit device (10) according to claim 11, wherein
the first circuit device element (4) is a portion of a patterned base layer on the substrate (1);
or
the first circuit device element (4) is a second Josephson junction, wherein the the first Josephson junction (2) and the second Josephson junction form a Josephson junction array (7).
